Europäisches Patentamt

European Patent Office

Office européen des brevets

(11) Publication number: **0 035 111**
**B1**

(12) **EUROPEAN PATENT SPECIFICATION**

(45) Date of publication of patent specification: **02.10.85**

(51) Int. Cl.⁴: **H 01 L 29/72, H 01 L 21/76**

(21) Application number: **81100493.6**

(22) Date of filing: **23.01.81**

(54) Structure and process for fabricating an integrated circuit.

(30) Priority: **03.03.80 US 126611**

(43) Date of publication of application:
**09.09.81 Bulletin 81/36**

(45) Publication of the grant of the patent:
**02.10.85 Bulletin 85/40**

(84) Designated Contracting States:
**DE FR GB IT**

(56) References cited:
**EP-A-0 004 292**
**US-A-4 139 442**
**US-A-4 157 269**

**IBM TECHNICAL DISCLOSURE BULLETIN, vol. 22, no. 9, February 1980, pages 4047-4051, New York (USA); T.H. YEH: "Self-aligned integrated NPN (vertical) and PNP (lateral) structures"**
**IBM TECHNICAL DISCLOSURE BULLETIN; vol. 22, no. 9, February 1980, pages 4054-4056, New York (USA); C.T. HORNG et al.: "Narrow base high performance bipolar structure"**

(73) Proprietor: **International Business Machines Corporation**
**Old Orchard Road**
**Armonk, N.Y. 10504 (US)**

(72) Inventor: **Cavaliere, Joseph Richard**
**Bykenhulle Road**
**Hopewell Junction New York 12533 (US)**
Inventor: **Horng, Cheng Tzong**
**6396 Gondola Way**
**San Jose California 95120 (US)**
Inventor: **Konian, Richard Robert**
**49 Brookland Farms Road**
**Poughkeepsie New York 12601 (US)**
Inventor: **Rupprecht, Hans Stephan**
**3505 Kamhi Drive**
**Yorktown Heights New York 10598 (US)**
Inventor: **Schwenker, Robert Otto**
**6359 Gondola Way**
**San Jose California 95120 (US)**

(74) Representative: **Gaugel, Heinz, Dipl.-Ing.**
**Schönaicher Strasse 220**
**D-7030 Böblingen (DE)**

(58) References cited:
**IBM TECHNICAL DISCLOSURE BULLETIN, vol. 22, no. 4, Spetember 1979, pages 1467-1468, New York (USA); I. ANTIPOV: "Process for separate control of intrinsic and extrinsic base doping in semiconductor device fabrication"**

## Description

This invention relates to the fabrication and structure of semiconductor devices, and, in particular, to very small integrated circuit bipolar devices with very high speed and very low power performance.

A planar self-aligned bipolar transistor structure in which the emitter, base and collector are self-aligned provides in a very small discrete area of a thin epitaxial layer on a planar surface of a silicon substrate a shallow depth emitter region, a shallow depth base region and a shallow depth active collector region in the order recited. The small discrete area of the thin epitaxial layer has vertical sidewalls.

Numerous integrated circuit devices, structures and techniques of fabricating same, are known to the prior art. The following prior art patents and summaries are submitted to generally represent the state of the art.

Reference is made to U.S. Patent No. 3,574,008 entitled "Mushroom Epitaxial Growth in Tier-Type Shaped Holes" granted April 6, 1971 to E. J. Rice. In the Rice patent, a wafer of substrate material of a given conductivity is provided. A passivating layer is then imposed upon the surface of the substrate wafer. Openings are etched in the passivating layer to expose the substrate layer, the openings having width dimensions varying from the bottom of the opening to the upper end thereof. The dimensions at the bottom of the openings are generally smaller than those at the upper end. A crystal of semiconductive material is grown epitaxially on the exposed substrate surface within the openings etched in the passivating layers. The crystals of semiconductive materials are grown until they overflow the openings onto the passivating layer and take on the appearance of mushrooms. The crystals are then lapped until the required surface condition is obtained.

Reference is made to U.S. Patent No. 3,655,457 entitled "Method of Making or Modifying a PN-junction by Ion Implantation" granted April 11, 1972 to M. C. Duffy et al. The Duffy et al. patent discloses a method for forming integrated circuits which have closely packed devices having unique electrical and dimensional characteristics. This is accomplished by heating a semiconductor substrate to a low temperature and then ion implanting N-type, P-type, electrically neutral and lifetime killer impurities into the regions comprising the various devices. Some of the more significant steps of the disclosure are heating the substrate to a temperature sufficiently high to anneal the defects created during implantation yet sufficiently low that there is essentially no thermal diffusion or movement of impurity ions; ion implanting immediately adjacent regions to form the closely packed devices; varying the ion beam energy to implant essentially constant impurity concentration regions; ion implanting lifetime killer impurities into selected regions; ion implanting electrically neutral impurity ions into junction regions to give a steeper gradient; and ion implanting impurity ions into previously implanted regions to alter or trim the region characteristics. Some additional significant steps of the disclosure for obtaining narrow base regions are ion implanting into the same region both N- and P- type impurities and then heating to cause one of the impurity types to diffuse out of the region, thereby forming a narrow base surrounding the emitter.

Reference is made to U.S. Patent No. 3,796,613 entitled "Method of Forming Dielectric Isolation for High Density Pedestal Semiconductor Devices" granted March 12, 1974 to I.E. Magdo et al. The Magdo et al. patent discloses a structure useable for integrated circuits, including field effect and/or bipolar transistors, wherein a significant savings in surface area and reduction in capacitances can be obtained over prior techniques. The method disclosed involves forming a layer of dielectric material upon a semiconductor body, having a diffused region where a bipolar device is to be formed, and then forming an opening in the layer to expose a part of the surface of the diffused region of the semiconductor body. An epitaxial layer of silicon is deposited on top. Single crystal silicon will grow over the exposed silicon area and if a diffused region is present in the substrate a pedestal will out diffuse through the same area from the buried diffused region. Polycrystalline silicon will grow on top of the dielectrical material. The pedestal is formed in a single crystal epitaxial layer of another impurity type. Two other active elements of a bipolar transistor, such as the emitter and intrinsic base regions, are then formed in the same single crystal epitaxial layer while the inactive area, such as the extrinsic base, is formed in polycrystalline silicon. A reach though is made through a dielectric layer to the third element of the transistor, that is the collector region.

Reference is made to U.S. Patent No. 3,975,221 entitled "Low Capacitance V Groove NOR Gate and Method of Manufacture" granted August 17, 1976 to T. J. Rodgers. The Rodgers patent discloses a MOS transistor having a surface diffused drain and a common substrate source. A heavily doped base layer and a lightly doped space charge region are provided between the drain and source regions. The gate is formed on the inclined surface of a V groove which penetrates into the transistor to the substrate exposing the base layer to the gate structure. The gate is formed in the V groove by a silicon oxide insulative layer and conductive layer. Appropriate leads contact the gate conductor and the drain.

Reference is made to U.S. Patent No. 4,047,217 entitled "High-Gain, High-Voltage Transistor Integrated Circuits" granted September 6, 1977 to T. McCaffrey et al. The McCaffrey patent discloses in a linear integrated circuit structure, the equivalent of a base function in a transistor, wherein the base function has a dual charge density, with the latter being relatively low in the lower active area of the base between PN junctions for high gain and high breakdown voltage, but high along the upper surface to prevent an unwanted inversion layer from occurring.

Reference is made to U.S. Patent No. 4,048,649 entitled "Superintegrated V-Groove Isolated Bipolar and VMOS Transistors" granted September 13, 1977 to R. Bohn. The Bohn patent discloses a semiconductor structure having a compatible mixture of bipolar and unipolar transistors. In the structure, a monocrystalline P-type silicon substrate is employed which has its 1-0-0 crystallographic planes at a face on which an n-epitaxial layer was grown. The epitaxial layer is divided into electrically isolated parts by V-grooves that extend down through the epitaxial layer and have their apices terminating in the substrate. A thin silicon dioxide film coats the V-grooves and those grooves are filled with polycrystalline silicon. Where it is desird to use the crystalline silicon as the insulated gate of a field effect transistor, the polycrystalline silicon is electrically conductive. Bases for bipolar transistors are formed by diffusion of an appropriate impurity into selected areas of the epitaxial layer. The emitters, drains, and sources are formed by diffusion of a different impurity. Each field effect transistor has its drain and source on adjacent parts of the epitaxial layer which are separated by the V-groove in which the gate is situated. The base and emitter of bipolar transistor may be situated on one isolated part and the collector may be situated on an adjacent part separated by a V-groove having an electrically conductive polycrystalline filler.

Reference is made to U.S. Patent No. 4,080,619 entitled "Bipolar Type Semiconductor Device" granted March 21, 1978 to K. Suzuki. The Suzuki patent discloses a bipolar transistor having a heavily doped emitter region, a base region, a collector region and a passivation layer or layers on said regions. The passivation layer formed on a surface end of a PN junction between the collector region and the base region is a polycrystalline silicon containing oxygen atoms in a range between 14 and 35 atomic percents. The other passivation layer formed on a surface end of the other PN junction between the base region and the lightly doped emitter region is made of silicon dioxide which covers also a surface end of lightly doped and heavily doped junctions between the two emitter regions.

The present trend in semiconductor technology is toward very large scale integration of devices with very high speed and low power requirements. The parameters that are essential to such high performance bipolar transistors are low parasitic capacitances as realized by a shallow vertical junction structure and small horizontal geometry. To achieve these goals it is necessary to make the devices in the integrated circuits as small as possible.

With the advances in semiconductor processing technologies, such as in the fields of ion implantation, deep dielectric isolation, electron beam and x-ray lithographies, reactive ion etching, advanced insulator and polysilicon deposition techniques, and metal lift-off processes, fabrication of the ultra-high performance integrated circuit devices can be achieved.

Ion implantation provides a means for precisely controlling the total amount of impurity transferred to the wafer. The impurity depth distribution is accurately controlled by implant energy. Unlike the conventional thermal diffusion process ion implantation is not a high temperature process. Thus, by using photoresist or metal masking, multiple impurity introduction operations can be achieved without resort to high temperatures. A final thermal drive-in diffusion is sufficient to anneal out the radiation damage caused by implantation, and obtain desired device junction depth. Consequently, integrated circuit devices can be made shallower, with greater precision of the impurity distribution using ion implantation technology.

As the semiconductor devices become shallower, it is desirable to reduce the overall junction area so as to reduce parasitic capacitance. Further reduction of device parasitic capacitance can be achieved by shrinking of device horizontal dimensions and using dielectric isolation. Dielectric isolation is a method of fabricating integrated circuits in which the device components are isolated by other than P-N junctions. A well known dielectric isolation, namely "Recessed Oxide Isolation" (ROI) is a commonly used process in present day technology. Using $Si_3N_4$ as the oxidation barrier, the ROI technique is done by etching grooves into the semiconductor wafer adjacent those regions in which PN junctions are to be formed. The silicon exposed by the grooves is then thermally oxidized to form recessed oxide regions providing dielectric isolation. The problem associated with the ROI is the formation of "bird's head" or "bird's beak" structure at the lateral edges of recessed oxide. The bird's head is undesirable because it can cause breaks or discontinuities in thin films covering the steps. The indefiniteness of bird's beak structure reduces the available active surface area and, therefore, imposes the need for wider tolerance of lateral dimension in the integrated circuit layout. A newly developed oxide isolation technique called "Deep Dielectric Isolation" (DDI) avoids the above mentioned problem. The DDI process utilizes reactive-ion etching (RIE) to form deep narrow trenches into the wafer surrounding those regions in which devices are to be formed. [Reference is made to U.S. Patent No. 4,104,086, entitled "Method for Forming Isolated Regions of Silicon Utilizing Reactive Ion Etching" granted August 1, 1978 to J. A. Bondur et al., and U.S. Patent No. 4,139,442 entitled "Reactive Ion Etching Method for Producing Deep Dielectric Isolation in Silicon" granted February 13, 1979 to J. A. Bondur et al., respectively assigned to the assignee of the subject application.] The trenches are overfilled with $SiO_2$ put down by chemical vapor deposition (CVD)

technique. The overfilled $SiO_2$ also planarizes the device surface. A blanket RIE back-etching to the semiconductor surface yields deep oxide isolation trenches. Unlike the bird's beak in ROI structures, sidewalls of the DDI structures are nearly vertical. The surface of DDI regions and the silicon where they are to be formed are coplanar. With the DDI, doping processes for various device regions are then self-aligned by oxide isolation. The self-aligned process eliminates precise mask alignment steps and also saves a number of mask steps in the device fabrication.

As mentioned above, DDI enables us to form devices with considerably smaller cell size than those formed by using either P-N isolation or by ROI. Further reduction of device horizontal dimensions requires the use of high resolution capabilities of lithography and etching processes. The electron beam lithography is the most promising method for delineating submicron size device patterns. For device window openings the reactive ion etch (RIE) is the most attractive alternative to the conventional wet solution etching. The RIE is a dry process having a directional etching characteristic. The etched device windows preserve the lithography defined etch mask dimensions, and the openings have vertical sidewalls. Thus, the E-beam lithography and reactive ion etching are compatible for fabricating very small device geometries.

For the very small bipolar transistor devices, as for example, micron size transistors, the base areas and, therefore, the collector-base parasitic capacitance is the most significant performance parameter. In the bipolar transistor the active base area is the region below the emitter. In the conventional transistors, fabricated in accordance with the prior art, the base contacts are formed above the inactive base area surrounding the emitter. The transistor base area that is needed to accommodate the emitter and base contacts is considerably larger than the active base area. To reduce the base area for making ultrahigh performance bipolar transistors, a different approach in providing the base contact can be found in "IBM Technical Disclosure Bulletin", Vol. 22. No. 9, February 1980, pages 4047 through 4051, entitled "Self-aligned integrated NPN (vertical) and PNP (lateral) structures" by T. H. Yeh. The transistor structure described is surrounded by oxide trenches which have nearly vertical sidewalls. A deep trench extends from an epitaxial silicon surface through a N+ sub-collector region into the P substrate. The width of the deep trench is about 2 µm to 3.0 µm. A shallow oxide trench extending from the epitaxial silicon surface to the upper portion of the N+ subcollector separates the base and collector contact. The surfaces of the dielectric isolation region and the silicon where the transistor structure is formed are coplanar, while the different regions of the transistor are situated one over the other in the epitaxial layer. The intrinsic base region situated between the essentially planar emitter and collector regions contacts a surrounding external base region, which encompasses also the emitter and collector regions. Apart from the processing difficulties the main disadvantage is the very large collector-base capacity besides a not to be neglected emitter-base capacity of this transistor structure, which is a serious drawback for a use in high speed units.

The invention as claimed is intended to remedy these drawbacks by providing a transistor structure in an integrated circuit, where the base area comprising that of the intrasinic and of the external base region is considerably reduced by applying advanced semiconductor processing techniques.

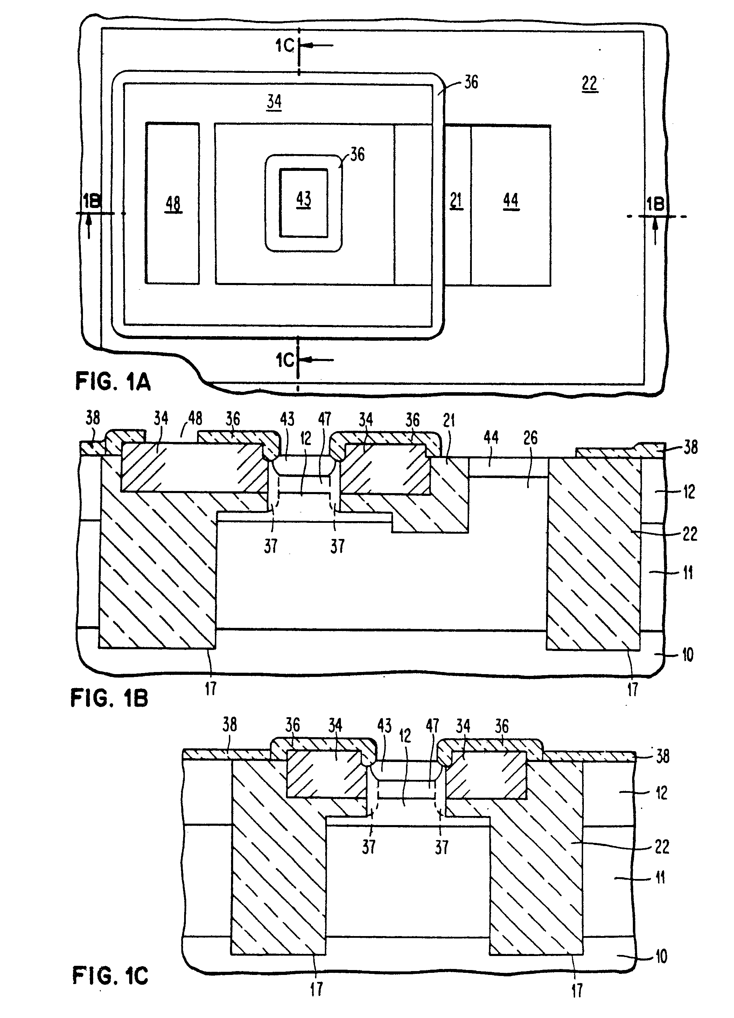

As shown in Figures 1A, 1B, 1C (and alternatively Figure 1BB), the fabricated bipolar transistor, in accordance with the invention, has a mesa-type structure. The transistor base dimension corresponds essentially to that of the emitter. This small base area results in low collector-base capacitance which is very important parameter in ultra-high performance integrated circuit devices. Contact to the transistor base in the structure, in accordance with the invention, is achieved by a thick heavily boron doped polysilicon layer which laterally surrounds the emitter and makes lateral contact to the base. The P+ polysilicon layer, which provides low base resistance, is formed within the oxide isolation trenches, thus minimizing the parasitic capacitance. The transistor active base is formed in place by a low dosage boron implantation made with its concentration peak below the emitter. The device thus formed will have a controllable narrow base width and a low external resistance. Both are essential to provide high speed and low power devices.

The emitter of the structure, in accordance with an embodiment of the invention is separated from the P+ polysilicon of the base contact by an $SiO_2$ dielectric layer or sleeve. This dielectric separation ensures that electrons injected into the base do occur at the bottom of the emitter. The dielectric sleeve of the emitter also eliminates the sidewall hole current component normally existing in conventional transistors. Thus, the bipolar transistor formed by the process, in accordance with the invention, has a high emitter injection efficiency and also has a high transistor current gains.

Furthermore, the fabricated small geometry devices have planarized surfaces. The planarized device structure ensures the thin film covering which is critical to the integration of very small devices.

The objects and advantages of the present invention will become more apparent from the following detailed description taken in conjunction with the accompanying drawings.

Figure 1A is a top view of a transistor structure in accordance with the invention.

Figure 1B is a cross-sectional view taken along the line 1B—1B of Figure 1A.

Figure 1C is a cross-sectional view taken along the line 1C—1C of Figure 1A.

Figures 2 through 12 are cross-sectional views disclosing the structure as successive stages, or steps, in the process in accordance with the invention.

Figure 1BB is a cross-sectional view of a second or alternative transistor structure in accordance with the invention. Figure 1BB of the alternative transistor structure corresponds from a cross-sectional drawing viewpoint to Figure 1B of the first transistor structure in accordance with the invention.

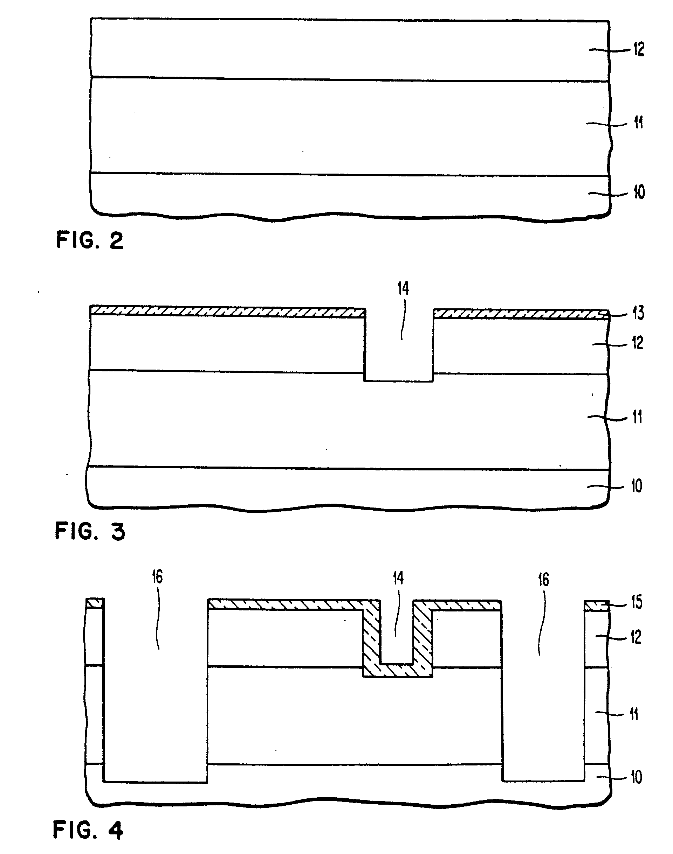

Figures 2 through 7, 7A, 8, 9A, 10, 11A and 12 through 18 are respectively cross-sectional views disclosing a second or alternative transistor structure in accordance with the invention.

Referring now to the drawings and Fig. 2 in particular, a P-type monocrystalline silicon 10 is the starting substrate. An N-type impurity is then introduced into 10 forming the subcollector 11. The impurity can be any suitable N-type impurity, as for example, arsenic and can be introduced into the wafer by any suitable technique such as capsule diffusion or ion implantation. An N-type epitaxial silicon layer 12 is then deposited on the subcollector 11. The thickness of the epitaxial silicon 12 is about 1—2μm.

As shown in Fig. 3, an oxide layer 13, approximately 300 nm thick, preferably deposited by CVD process is formed on epitaxial layer 12. A lithography step is applied to form a resist window which overlies the intended shallow trench. The oxide 13 defined by the resist is then opened by using reactive ion etch (RIE) technique. Using the unetched oxide layer 13 as an etch mask, the RIE is further used to etch through the epitaxial layer 12 to form a shallow trench 14.

Referring to Figure 4, an oxide layer 15, approximately 700 nm thick, is deposited on the wafer by a CVD process.

Subsequently, a lithography step is performed to form a resist window which overlies the deep trench to be fabricated. The oxide 15, defined by the resist, is then opened by RIE. Using the unetched oxide 15 as an etch mask, RIE is next used to etch through the epitaxial silicon layer 12 and subcollector 11 to form the deep trench 16. Subsequently, using a thin CVD oxide layer (not shown in Fig. 4) to protect sidewalls of the deep trench 16, a boron implantation is made to form channel stop 17 in the bottom of the deep trench.

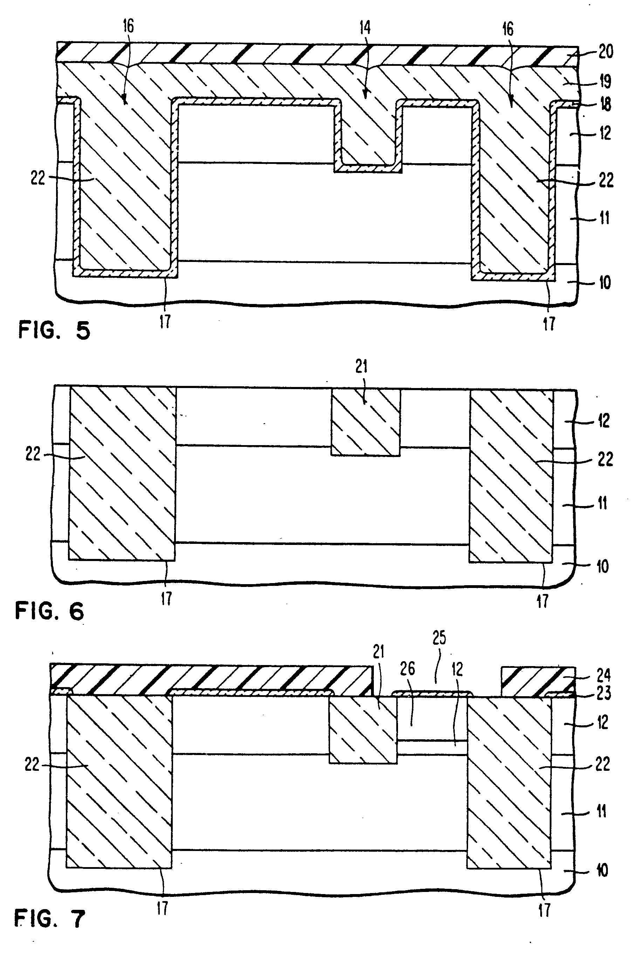

After stripping the CVD oxide, the wafer is thermally oxidized to form a high quality $SiO_2$ layer 18 over the exposed silicon surface. As shown in Figure 5, a thick oxide layer 19 formed by low pressure CVD technique is used to fill the shallow trench 14 and deep trench 16 and also planarize the wafer surface. Next a blanket resist 20 is applied and appropriately treated to further planarize the surface 19.

Referring now to Figures 5 and 6, the subsequent process step is to use RIE to thin back the resist layer 20 and the oxide layer 19. Of primary importance is that the RIE etch rate of resist is nearly equal to that of $SiO_2$. Thus, with an equal thickness of resist and $SiO_2$ everywhere over the

wafer, a back-etching to silicon 12 will yield a planar surfce with filled in shallow trench 21 and deep trench 22 as shown in Figure 6.

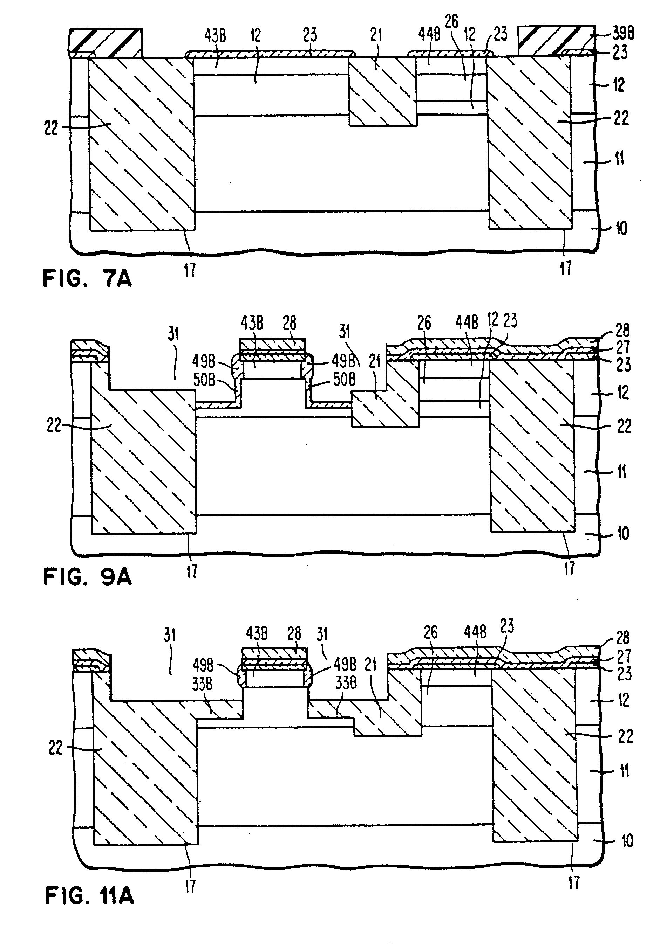

As demonstrated in Figure 7, a $SiO_2$ layer 23, approximately 30 nm thick, preferably formed by thermal oxidation, is grown on the silicon surface 12. A resist layer 24 is deposited on the wafer surface. The resist layer 24 is exposed and developed to form a block-out window 25 which overlies the intended transistor reach through region. A suitable N-type impurity preferably phosphorous, is ion-implanted through oxide layer 23 into the epitaxial layer 12 to form N+ reach through region 26. The resist layer 24 is subsequently stripped.

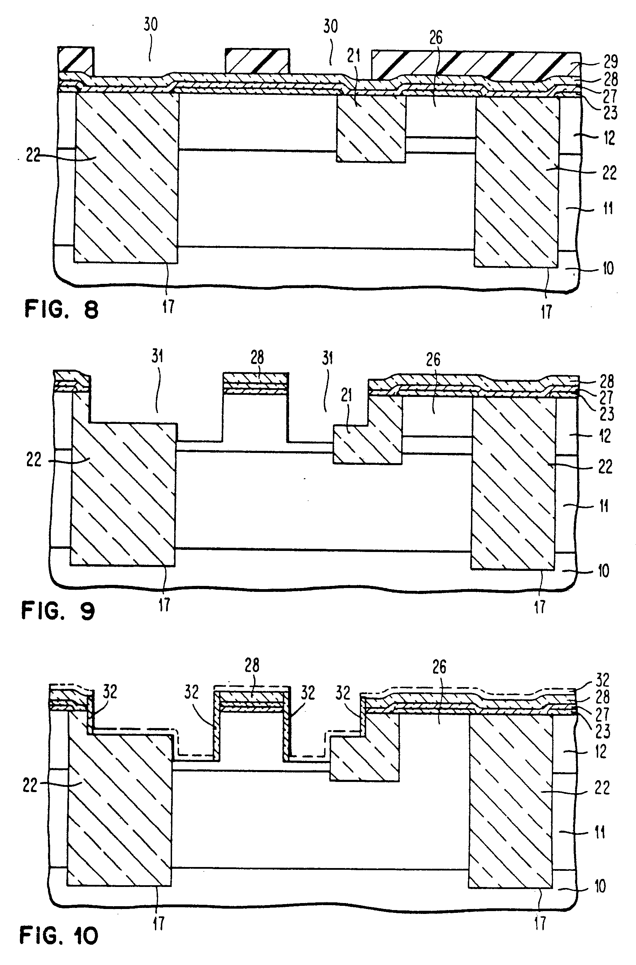

As shown in Figure 8, a $Si_3N_4$ layer 27 of approximately 50 nm thick is deposited on the wafer. A $SiO_2$ layer 28 is next formed on the $Si_3N_4$ layer 27. The thickness of the $SiO_2$ layer 28 is approximately 300 nm. Preferably both $Si_3N_4$ layer 27 and $SiO_2$ layer 28 are formed by CVD processes. As demonstrated in Figure 8, a resist layer 29 is coated and subsequently exposed and developed to form an opening 30 which defines the intended polysilicon base contact region. Using the resist layer 29 as an etch mask, the $SiO_2$ layer 28, $Si_3N_4$ layer 27 and $SiO_2$ layer 23 are etched by using an RIE process. Preferably, $CF_4/H_2$ RIE which has a very small silicon etch rate is used to etch the $SiO_2/Si_3N_4/SiO_2$ layer. An RIE process which has a comparable etch rate for $SiO_2$ and Si is then used to etch into the epitaxial layer 12 and the oxide isolation trenches 21 and 22. The etched depth is determined by either the numbers of the fringes displayed by the end-point detector or by the etching time. As shown in Figure 9, the RIE etched groove 31 has nearly vertical sidewalls.

As shown in Figure 10, a conformal CVD $Si_3N_4$ layer 32, approximately 80 nm thick, is deposited onto the surface of the device structure. A blanket RIE process is then used to directionally remove the deposited $Si_3N_4$ layer 32 indicated by the dash line. The $Si_3N_4$ layer 32 formed on the device sidewalls would not be stripped by the directional RIE.

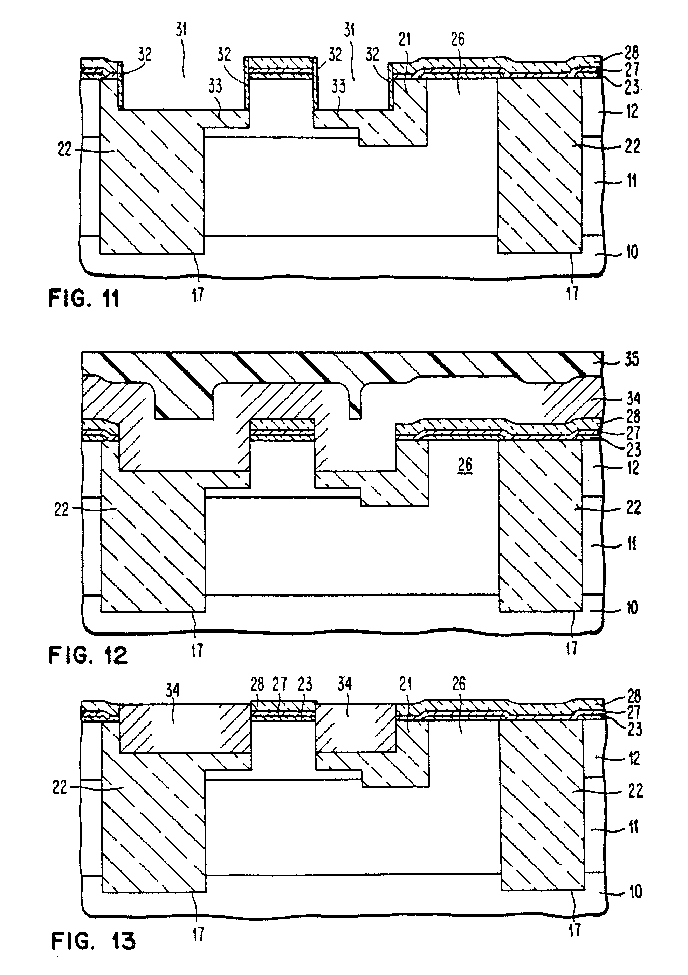

With $Si_3N_4$ layer 32 protecting the device sidewalls, as shown in Figure 11, the exposed silicon at the bottom of the groove 31 is thermally oxidized to form a thick $SiO_2$ layer 33. The $SiO_2$ layer 33 is approximately 300 nm thick and, preferably, is formed by low temperature-high pressure oxidation process so as to minimize outdiffusion of the N+ buried layer 11. After formation of $SiO_2$ layer 33, the sidewall $Si_3N_4$ layer 32, is then removed by using warm $H_3PO_4$ solution.

As illustrated in Figure 12, a heavily doped P-type polysilicon layer 34 is deposited on the wafer to fill the groove. The polysilicon layer 34 is formed preferably by a low pressure CVD process to achieve good thickness uniformity. Doping of the polysilicon layer 34 can be done in-situ during CVD. Alternative intrinsic polysilicon can be deposited and subsequently doped by boron implantation. A resist layer 35 is next deposited and treated appropriately to obtain planarization of the wafer surface.

The subsequent process step is to etch back the resist layer 35 and polysilicon layer 34 by RIE. The RIE etch rate of resist 35 is preferably equal to or slightly less than that of polysilicon 34. When the $SiO_2$ layer 28 is reached, as shown in Figure 13, the etch-back is stopped. Subsequently, the $SiO_2$ layer 28 is stripped by using buffer-HF solution.

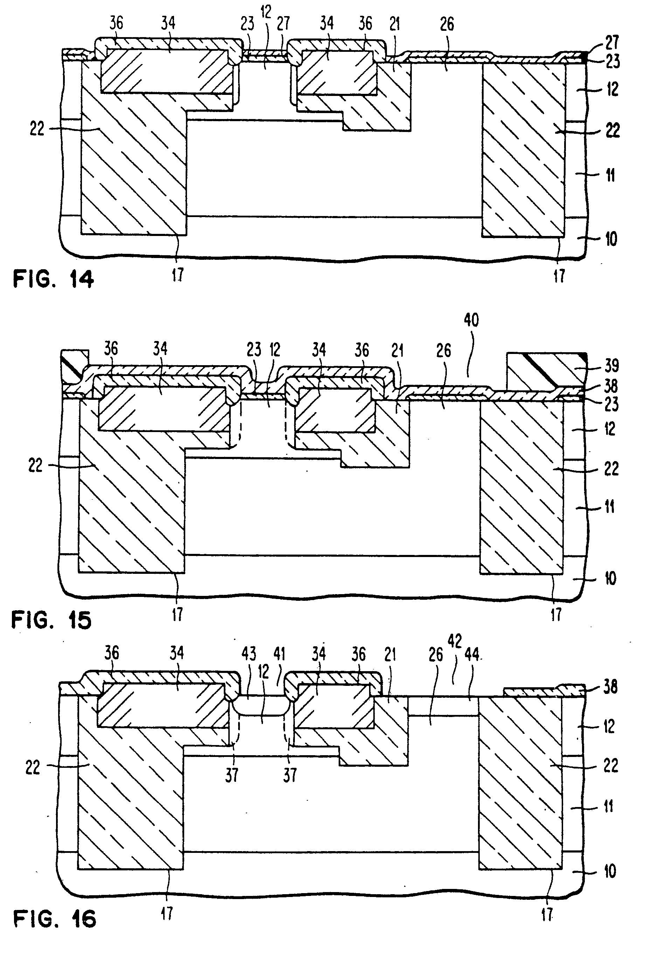

Referring to Figure 14, a thermal oxidation is performed to grow a relatively thick oxide layer 36 on the exposed polysilicon 34. The thickness of the oxide layer 36 is approximately 200 nm and preferably is formed by low temperature-high pressure oxidation process. The low temperature oxidation minimizes outdiffusion of P-type impurity from polysilicon 34 into the epitaxial silicon 12. Outdiffusion of P-type impurity forms a thin sleeve of P-region 37 in the N-type epitaxial silicon region 12. This P-region 37 is the external base of the intended transistor. Subsequently, the $Si_3N_4$ layer 27 is stripped by using warm $H_3PO_4$ solution.

As shown in Figure 15, a conformal $SiO_2$ layer 38 approximately 200 nm thick is formed by CVD process. A resist layer 39 is next coated and subsequently exposed and developed to form a block-out window 40 defining the transistor region. Referring to Figures 15 and 16 a $CF_4/H_2$ RIE is used to etch the deposited $SiO_2$ layer 38 and layer 23 to open the emitter contact 41 and collector contact 42. As can be seen in Figure 16, the side-oxide which spaces the emitter contact 41 from polysilicon 34 is thicker than that of Figure 14.

As demonstrated in Figure 16, an N-type impurity is introduced into windows 41 and 42 forming the emitter 43 and collector contact 44. The impurity, preferably arsenic, can be introduced into the wafer by any suitable technique, as for example, capsule diffusion or ion implantation.

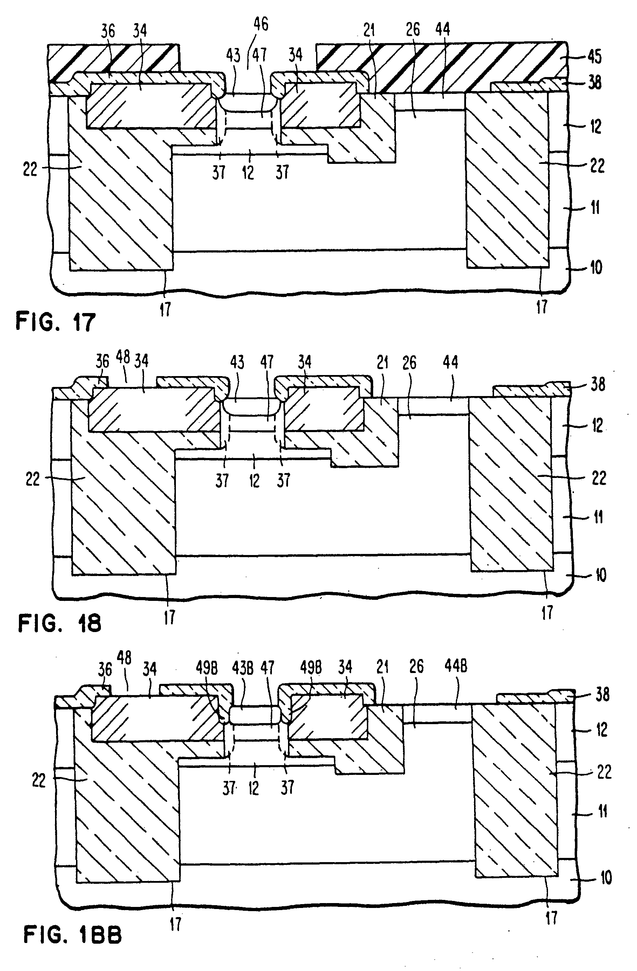

Referring now to Figure 17, a resist layer 45 is applied and subsequently exposed and developed to form a block-out window 46 for intrinsic base boron implant. The boron implantation is made into epitaxial layer 12. The energy for boron implantation is such that its concentration peak is just beyond the emitter 43. The block-out resist layer 45 is then stripped, and the device is heat-treated at 900°C to activate the implanted boron to form intrinsic base 47.

As shown in Figure 18, a contact opening 48 to the P+ polysilicon is formed by lithography and an etching process. The device is then ready for metallization.

A slight modification of the process described above leads to the improved transistor structure shown in Figure 1BB. The transistor of Figure 1BB has an improved emitter structure over that of Figure 1B by having an oxide isolated sidewall 49B around the emitter sidewall. The dielectric sleeve 49B of the emitter eliminates the sidewall hole current component.

The process modification that is needed to obtain the transistor structure of Figure 1BB is described as follows:

Referring to Figures 2 through 7, the initial process steps for forming the shallow 21 and deep 22 oxide isolation trenches and subsequently the formation of reach-through phosphorous implantation region 26 are the same as those described earlier herein.

Reference is made to Figure 7A for process deviation. It starts by forming a block-out resist mask 39B which defines the transistor region. An arsenic implant appropriate for forming N+ shallow emitter layer 43B is done into the wafer. This implant also provides collector reach through region 44B. After stripping the block-out resist mask 39B the wafer is then heat-treated to obtain a desired emitter junction depth.

Referring to Figures 8 and 9, the same processing steps which lead to formation of groove 31 (earlier herein) are used for the modified structure. The subsequent process is to use low temperature (800—850°C) oxidation to form a 200 nm thick layer of thermal oxide 49B on the sidewalls of the N+ doped emitter layer 43B. The oxide 50B that is grown on the sidewalls of the N— epitaxial layer 12 by the low temperature oxidation is less than 50 nm. The structure is shown in Figure 9A.

Referring to Figures 10 and 11, the processes that are used (earlier herein) for forming the sidewall $Si_3N_4$ layer 32 and formation of thick oxide 33 at the bottom of the groove 31 are also used for the modified structure. After formation of the oxide 33 at the bottom of the groove the $Si_3N_4$ layer 32 is stripped by using $H_3PO_4$ solution. The subsequent step is to use buffer-HF solution to etch oxide for a time more than sufficient to completely remove the thin oxide 50B formed on the sidewall of the N— epitaxial layer 12 but still leave a substantially thick side-oxide layer 49B around the N+ emitter sidewall. This modified structure is shown in Figure 11A.

The subsequent process steps which lead to the fabrication of the improved transistor structure shown in Figure 1BB are the same as set forth earlier herein (reference is made to Figures 12 through 18).

While the invention has been particularly shown and described with reference to the preferred embodiments thereof, it will be understood by those skilled in the art that various changes in form and detail may be made therein without departing from the scope of the invention.

**Claims**

1. An integrated circuit comprising a vertical bipolar transistor structure formed in a relatively thin epitaxial layer (12) deposited on a laterally extending subcollector (11) formed in a substrate (10) of opposite conductivity type, said transistor structure being surrounded by vertical isolating sidewalls (21, 22) one of which extends to the planar surface of said substrate (10), said transistor structure containing in the order recited a shallow depth emitter region (43) having an exposed planar surface, a shallow depth intrinsic base region (47) of said opposite conductivity type, and a shallow depth active collector region formed as a part of said epitaxial layer (12) beneath said base region (47) to provide an essentially flat base-collector junction residing directly beneath and being substantially uniformly spaced from the base-emitter junction and having an area essentially equal to the area of said base-emitter junction, and said transistor structure having additionally a region (37) of said opposite conductivity type directly surrounding at least said intrinisic base region (47) as well as said active collector region, and serving as the external base of the transistor, characterized by:

a polysilicon region (34) of relatively high conductivity of said opposite conductivity type laterally encompassing said additional region (37) being in the form of a thin sleeve, by only surrounding said emitter region (43) and said intrinsic base region (47), providing electrical contact to said intrinsic base region (47), and carried by portions of said sidewalls (21, 22) to electrically isolate said polysilicon region (34) from said active collector region and said sub-collector (11).

2. An integrated circuit comprising a transistor structure according to claim 1, characterized by:

a dielectric sleeve (49B) surrounding said emitter region (43B) and electrically isolating said polysilicon region (34) from said emitter region (43).

3. A process for fabricating an integrated circuit according to claims 1 and 2, comprising the following steps subsequent to the deposition of said epitaxial layer (12) on the planar surface of said sub-collector region (11) of a second conductivity type formed in the semiconductor substrate (10) of a first conductivity type, and forming first (22), second (21) and third (22) spaced apart oxide isolation regions extending through said epitaxial layer into said sub-collector region towards said substrate:

a. form a first oxide layer (23) on said epitaxial layer (12) by thermal oxidation;

b. utilizing a suitable block-out mask (24), ion implant impurities of the second conductivity type into said epitaxial layer (12) in a region extending from said second recessed oxide region (21) to said third recessed oxide region (22) thereby forming a heavily doped collector reach through region (26) and remove the block-out mask (24);

c. form a first silicon nitride layer (27, Fig. 8) on said first oxide layer (23);

d. form a second oxide layer (28) on said first silicon nitride layer (27);

e. form a mask (29) having first and second spaced apart window regions (30), said window regions, respectively exposing discrete regions of said second oxide layer (28), said first window region extending over a portion of said first recessed oxide isolation region (22) and a portion of said epitaxial layer (12) towards said second recessed oxide isolation region (21) and said epitaxial layer (12) in the direction of said recessed oxide isolation region (22), said first and second window regions (30) being spaced apart a relatively small distance, d;

f. utilizing reactive-ion etch techniques and said first and second window regions (30) for forming grooves (31) etch said second oxide layer (28), said first silicon nitride layer (27), said first oxide layer (23), the corresponding portion of said oxide isolation regions (21, 22) and of said epitaxial layer (12) towards the surface of said subcollector region (11), whereby the portion of said epitaxial layer (12) remaining between the rests of said first (22) and second (21) recessed oxide isolation regions has a relatively small width and vertical sidewalls;

g. remove said mask (29) formed in step e;

h. chemically vapor deposit (CVD) a second silicon nitride layer (32) on the surface of the whole structure;

i. utilize reactive ion etching (RIE) to remove predetermined portions of the second silicon nitride layer (32);

j. form an oxide layer (33) over the exposed surface of said epitaxial layer (12);

k. remove the remaining portions of said second silicon nitride layer (32);

l. form a layer (34) of doped polysilicon of a second conductivity type over the surface of the whole structure;

m. utilizing photoresist (35) planarize said substrate surface;

n. utilizing reactive ion etch (RIE) techniques etch back said photoresist (35) and polysilicon (34) to stop at the surface of said second oxide layer (28);

o. remove said second oxide layer (28); and

p. form an oxide coating (36) on said polysilicon (34).

4. A process for fabricating an integrated circuit according to claim 3 including the further steps:

a. remove said first layer (27, Fig. 14) of silicon nitride and said first layer (23, Fig. 14) of oxide over emitter and collector contact areas;

b. ion implant emitter region (43, Fig. 16) with impurities of the first type;

c. ion implant active base region (47, Fig. 17) with impurities of the first type.

5. A process for fabricating an integrated circuit according to claims 1 and 2, comprising the following steps subsequent to the deposition of said epitaxial layer (12) on the planar surface of said sub-collector region (11) of a second conductivity type formed in the semiconductor substrate (10) of a first conductivity type, and forming first (22), second (21) and third (22) spaced apart oxide isolation regions extending through said epitaxial layer into said sub-collector region towards said substrate;

a. form a block-out mask (39B, Fig. 7A) to define the transistor region; and

b. implant ions of said second conductivity type to provide said emitter region (43B, Fig. 9A) and said collector reach through region (44B, Fig. 9A) and remove the block-out mask;

c. etch grooves (31) to both sides of said transistor region extending into the recessed oxide isolation regions (21, 22).

6. A process for fabricating an integrated circuit according to claim 5, characterized by further process steps:

a. by low temperature oxidation form a 200 nm thick oxide layer (49B, Fig. 9A) on exposed sidewalls of said emitter region (43B, Fig. 9A) and a 50 nm thick oxide layer (50B, Fig. 9A) on the portion of said epitaxial layer (12, Fig. 9A) there beneath;

b. using an oxide etching solution for sufficient time, remove the thin oxide layer (50B, Fig. 11A) deposited on the sidewalls of the epitaxial layer (12, Fig. 11A) by still leaving a portion of the thick oxide layer (49B) deposited around the emitter sidewall;

c. fill the groove (31) with heavily doped polysilicon (34).

## Patentansprüche

1. Integrierte Schaltung mit einer bipolaren Transistorstruktur in einer relativ dünnen Epitaxieschicht (12) auf einem seitlich sich erstreckenden Subkollektor (11) in einem Substrat (10) des entgegengesetzten Leitfähigkeitstyps, wobei diese Transistorstruktur von vertikalen Seitenisolierwänden (21, 22) umgeben ist, deren eine sich zur ebenen Oberfläche des Substrats (10) erstreckt, wobei die Transistorstruktur in der aufgeführten Reihenfolge eine flache Emitterzone (43) mit einer freiliegenden planaren Oberfläche aufweist, eine flache intrinsische Basiszone (47) des entgegengesetzten Leitfähigkeitstypes sowie eine flache aktive Kollektorzone als Teil der Epitaxieschicht (12) unter der Basiszone (47), um einen im wesentlichen flachen Basis-Kollektorübergang vorzusehen, welcher direkt unter dem Basis-Emitterübergang vorgesehen und im wesentlichen einheitlich davon beabstandet ist, und mit einem Bereich, der im wesentlichen dem Bereich das Basis-Emitterübergangs gleich ist, und wobei die Transistorstruktur zusätzlich einen Bereich (37) des entgegengesetzten Leitfähigkeitstyps aufweist, welcher zumindest die intrinsische Basiszone (47) umgibt sowie die aktive Kollektorzone, und welcher als die externe Basis der Transistors dient, gekennzeichnet durch:

einen Polysiliciumbereich (34) von relativ hoher Leitfähigkeit des entgegengesetzten Leitfähigkeitstyps, der den zusätzlichen Bereich (37) seitlich umgibt, welcher die Form einer dünnen Manschette aufweist, indem nur die Emitterzone (43) und die intrinsische Basiszone (47) umgeben werden und indem ein elektrischer Kontakt mit der intrinsischen Basiszone (47) hergestellt wird, und der getragen wird von Teilen der Seitenwände (21, 22), um den Polysiliciumbereich (34) von der aktiven Kollektorzone und dem Subkollektor (11) elektrisch zu isolieren.

2. Integrierte Schaltung mit einer Transistorstruktur nach Anspruch 1, gekennzeichnet durch: eine dielektrische Manschette (49B), welche die Emitterzone (43B) umgibt und den Polysiliciumbereich (34) von der Emitterzone (43) elektrisch isoliert.

3. Verfahren zum Herstellen einer integrierten Schaltung nach den Ansprüchen 1 und 2, mit den folgenden Schritten nach dem Aufbringen der Epitaxieschicht (12) auf der ebenen Oberfläche der Subkollektorzone (11) eines zweiten Leitfähigkeitstyps im Halbleitersubstrat (10) eines ersten Leitfähigkeitstyps, und zur Bildung von ersten (22), zweiten (21) und dritten (22) beabstandeten Oxidisolationsbereichen, welche sich durch die Epitaxieschicht in die Subkollektorzone zum Substrat erstrecken:

a. Bildung einer ersten Oxidschicht (23) auf der Epitaxieschicht (12) durch thermische Oxidation;

b. unter Verwendung einer entsprechenden Ausblendmaske (24) Ionenimplantation von Störstellen des zweiten Leitfähigkeitstyps in der Epitaxieschicht (12), in einem Bereich, welcher sich von dem zweiten abgesenkten Oxidbereich (21) zum dritten abgesenkten Oxidbereich (22) erstreckt und dadurch eine stark dotierte Kollektor-Durchgriffszone (26) bildet, sowie Entfernen der Ausblendmaske (24);

c. Bilden einer ersten Siliciumnitridschicht (27, Fig. 8) auf den ersten Oxidschicht (23);

d. Bilden einer zweiten Oxidschicht (28) auf der ersten Siliciumnitridschicht (27);

e. Bilden einer Maske (29) mit ersten und zweiten beabstandeten Fensterbereichen (30), die jeweils getrennte Bereiche der zweiten Oxidschicht (28) freilegen, wobei der erste Fensterbereich sich über einen Teil des ersten abgesenkten Oxidisolierungsbereichs (22) erstreckt sowie einen Teil der Epitaxieschicht (12) zur zweiten abgesenkten Oxidisolationsschicht (21) und die zweite Epitaxieschicht (12) in Richtung des abgesenkten Oxidisolierungsbereiches (22), wobei die ersten und zweiten Fensterbereiche (30) durch eine relativ geringe Entfernung d voneinander beabstandet sind;

f. unter Verwendung von Techniken des reaktiven Ionenätzens und der ersten und zweiten Fensterbereiche (30) zur Bildung von Nuten (31) Ätzen der zweiten Oxidschicht (28), der ersten Siliciumnitridschicht (27), der ersten Oxidschicht (23), der entsprechenden Teils des Oxidisolierungsbereichs (21, 22) und der Epitaxieschicht (12) zur Oberfläche des Subkollektorbereichs (11), wodurch der Teil der Epitaxieschicht (12), der zwischen den Resten der ersten (22) und zweiten (21) abgesenkten Oxidisolationsbereiche verbleibt, eine relativ geringe Breite und vertikale Seitenwände aufweist;

g. Entfernen der in Schritt e gebildeten Maske (29);

h. chemisches Aufdampfen (CVD) einer zweiten Siliciumnitridschicht (32) auf der Oberfläche der Gesamtstruktur;

i. Anwnden des reaktiven Ionenätzens (RIE) zur Enfernung bestimmter Teile der zweiten Siliciumnitridschicht (32);

j. Bilden einer Oxidschicht (33) über der freiliegenden Oberfläche der Epitaxieschicht (12);

k. Entfernen der verbleibenden Teile der zweiten Siliciumnitridschicht (32);

l. Ausbilden einer Schicht (34) aus dotiertem Polysilicium eines zweiten Leitfähigkeitstyps über der Oberfläche der Gesamtstruktur;

m. unter Anwendung von Photoresist (35) Ebnen der Substratoberfläche;

n. unter Anwendung von reaktivem Ionenätzen (RIE) Zurückätzen des Photoresists (35) und des Polysiliciums (34) bis zur Oberfläche der zweiten Oxidschicht (28);

o. Entfernen der zweiten Oxidschicht (28), und

p. Ausbilden eines Oxidüberzugs (36) auf dem Polysilicium (34).

4. Verfahren zum Herstellen einer integrierten Schaltung nach Anspruch 3, umfassend die folgenden weiteren Schritte:

a. Enternen der ersten Siliciumnitridschicht (27, Fig. 14) und der ersten Oxidschicht (23, Fig. 14) über den Kontaktzonen von Emitter und Kollektor;

b. Ionenimplantation der Emitterzone (43, Fig. 16) mit Störstellen des ersten Typs;

c. Ionenimplantation der aktiven Basiszone (47, Fig. 17) mit Störstellen der ersten Typs.

5. Verfahren zum Herstellen einer integrierten Schaltung nach den Ansprüchen 1 und 2, mit den folgenden Schritten anschließend an das Aufbringen der Epitaxieschicht (12) auf den ebenen Oberfläche der Subkollektorzone (11) eines zweiten Leitfähigkeitstyps im Halbleitersubstrat (10) eines ersten Leitfähigkeitstyps, und Ausbilden von ersten (22), zweiten (21) und dritten (22) beabstandeten Oxidisolationsbereichen, die sich durch die Epitaxieschicht in die Subkollektorzone zum Substrat erstrecken:

a. Ausbilden einer Ausblendmaske (39B, Fig. 7A) zur Definition der Transistorzone; und

b. Implantation von Ionen des zweiten Leitfähigkeitstyps für die Emitterzone (43B, Fig. 9A) und die Kollektor-Durchgriffszone (44B, Fig. 9A), und Entfernen der Ausblendmaske;

c. Ätzen von Nuten (31) auf beiden Seiten der Transistorzone, welche sich in die abgesenkten Oxidisolationsbereiche (21, 22) erstrecken.

6. Verfharen zum Herstellen integrierter Schaltungen nach Anspruch 5, gekennzeichnet durch die folgenden Verfahrensschritte:

a. bei einer Oxidation niedriger Temperatur Ausbilden einer Oxidschicht (49B, Fig. 9A) von 200 nm Dicke auf freiliegenden Seitenwänden der Emitterzone (43B, Fig. 9A) un eine Oxidschicht (50B, Fig. 9A) von 50 nm Dicke auf dem darunterliegenden Teil der Epitaxieschicht (12, Fig. 9A);

b. unter Verwendung einer zeitlich ausreichenden Oxidätzlösung Entfernung der dünnen Oxidschicht (50B, Fig. 11A) auf den Seitenwänden der Epitaxieschicht (12, Fig. 11A) durch das Belassen eines Teils der dicken Oxidschicht (49B), welche um die Emitter-Seitenwände aufgebracht wurde;

c. Füllen der Nuten (31) mit stark dotiertem Polysilicium (34).

**Revendications**

1. Circuit intégré comportant une structure de transistor bipolaire vertical, constituée par une couche épitaxiale relativement mince (12) déposée sur une zone sous collecteur (11) s'étendant latéralement et formée dans un substrat (10) possédant un type de conductivite opposé, ladite structure du transistor étant entourée par des parois latérales isolantes verticales (21, 22) dont l'une s'étend jusqu'à la surface plane dudit substrat (10), ladite structure de transistor contenant, dans l'ordre indiqué, une région d'émetteur de faible profondeur (43) comportant une surface plane à nu, une région de base intrinsèque de faible profondeur (47) possédant ledit type de conductivité opposé, et une région de collecteur active de faible profondeur réalisée en tant que partie de ladite couche épitaxiale (12) au-dessous de ladite région de base (47) de manière à fournir une jonction base-collecteur essentiellement plane, située directement au-dessous de ladite région et étant distante d'une manière essentiellement uniforme de la jonction base-émetteur et possédant une surface essentiellement égale à la surface de cette jonction, et ladite structure de transistor comportant en outre une région (37) possédant ledit type de conductivité opposé et entourant directement au moins ladite région de base intrinsèque (47) ainsi que ladite région active de collecteur et servant de base extérieure pour la transistor, caractérisé par:

une région en polysilicium (34) possédant une conductivité relativement élevée du type opposé et entourant latéralement ladite région supplémentaire (37), qui possède la forme d'un manchon mince en entourant uniquement ladite région d'émetteur (43) et ladite région de base intrinsèque (47), en établissant un contact électrique avec cette région de base intrinsèque, et portée par une partie desdites parois latérales (21, 22) de manière à réaliser électriquement ladite région en polysilicium (34) par rapport à ladite région active de collecteur et à ladite zone sous collecteur (11).

2. Circuit intégré comprenant une structure de transistor selon la revendication 1, caractérisé par:

un manchon diélectrique (49B) entourant ladite région d'émetteur (43B) et isolant électriquement ladite région en polysilicium (34) par rapport à ladite région d'émetteur (43).

3. Procédé pour fabriquer un circuit intégré selon les revendications 1 et 2, incluant les phases opératoires suivantes intervenant à la suite du dépôt de ladite couche épitaxiale (12) sur la surface plane de ladite zone sous collecteur (11) possédant un second type de conductivité et ménagée dans le substrat semiconducteur (10) possédant un premier type de conductivité, et à la suite de la formation d'une première (22), d'une seconde (21) et d'une troisième (22) régions isolantes d'oxyde distantes les unes des autres et s'étendant à travers ladite couche épitaxiale pour pénétrer dans ladite région sous collecteur, en direction dudit substrat:

a. formation d'une première couche d'oxyde (23) sur ladite couche épitaxiale (12) par oxydation thermique;

b. moyennant l'utilisation d'un masque de blocage approprié (24), implantation d'ions d'impuretés du second type de conductivité dans ladite couche épitaxiale (12) dans une région s'étendant depuis la seconde région d'oxyde en renforcement (21) jusqu'à ladite troisième région d'oxyde en renforcement (22), de manière à former de ce fait une région fortement dopée (26) de traversée jusqu'au collecteur, et élimination du masque de blocage (24);

c. formation d'une première couche de nitrure de silicium (27, Figure 8) sur ladite première couche d'oxyde (23);

d. formation d'une seconde couche d'oxyde (28), ladite première couche de nitrure de silicium (27);

e. formation d'un masque (29) possédant une première et une seconde régions formant fenêtres (30) distantes les unes des autres, qui mettent à nu des régions discrètes de ladite seconde couche d'oxyde (28), ladite première région formant fenêtre s'étendant audessus d'une partie de ladite première région isolante d'oxyde en renforcement (22) et sur une partie de ladite couche épitaxiale (12) en direction de ladite seconde région isolante d'oxyde en renforcement (21) et de ladite couche épitaxiale (12) dans la direction de ladite région isolante d'oxyde en renfoncement (22), lesdites première et seconde régions formant fenêtres (30) étant séparées l'une de l'autre par une distance d relativement faible;

f. moyennant l'utilisation de techniques de corrosion ionique réactive et desdites première et seconde régions formant fenêtres (30) pour former des gorges (31), mise en oeuvre d'une corrosion de ladite seconde couche d'oxyde (28), de ladite première couche de nitrure de silicium (27), de ladite première couche d'oxyde (23), de la partie correspondante desdites régions isolantes d'oxyde (21, 22) et de ladite couche épitaxiale (12) en direction de la surface de ladite région sous collecteur (11), ce qui a pour effet que la partie de ladite couche épitaxiale (12) subsistant entre les restes des première (22) et seconde (21) régions isolantes d'oxyde en renforcement possède une largeur relativement faible et des parois latérales verticales;

g. élimination dudit masque (29) formé lors de la phase opératiore e;

h. dépôt chimique en phase vapeur (CVD) d'une seconde couche de nitrure de silicium (32) à la surface de l'ensemble de la structure;

i. utilisation de la corrosion ionique réactive (RIE) afin d'éliminer des parties prédéterminées de la seconde couche de nitrure de silicium (32);

j. formation d'une couche d'oxyde (33) sur la surface à nu de ladite couche épitaxiale (12);

k. élimination des parties restantes de ladite seconde couche de nitrure de silicium (32);

l. formation d'une couche (23) de polysilicium dopé possédant un second type de conductivité sur la surface de l'ensemble de la structure;

m. moyennant l'utilisation d'une résine photosensible (35), planéification de ladite surface du substrat;

n. moyennant l'utilisation de techniques de corrosion ionique réactive (RIE), rétro-corrosion de ladite résine photosensible (35) et du polysilicium (34) pour obtenir un arrêt au niveau de la surface de ladite sceonde couche d'oxyde (28);

o. retrait de ladite seconde couche d'oxyde (28); et

p. formation d'un revêtement d'oxyde (36) sur ledit silicium (34).

4. Procédé pour fabriquer un circuit intégré selon la revendication 3, incluant les phases opératoires supplémentaires:

a. élimination de ladite première couche (27, figure 14) de nitrure de silicium, et de ladite première couche (23, figure 14) de l'oxyde situé au-dessus des zones de l'émetteur et du contact de collecteur;

b. implantation d'ions dans la région d'émetteur (43, figure 16) à l'aide d'impuretés du premier type;

c. implantation d'ions dans la région de base active (47, figure 17) avec des impuretés du premier type.

5. Procédé pour fabriquer un circuit intégré selon les revendications 1 et 2, incluant les phases opératoires suivantes intervenant à la suite du dépôt de ladite couche épitaxiale (12) sur la surface plane de ladite région sous collecteur (11) d'un second type de conductivité formée dans le substrat semiconducteur (10) possédant un premier type de conductivité, et à la suite de la formation de la première (22), de la seconde (12) et de la troisième (22) régions isolantes d'oxyde distantes les unes des autres, qui s'étendent à travers ladite couche épitaxiale en pénétrant dans ladite région sous-collecteur en direction dudit substrat:

a. formation d'un masque de blocage (49B, figure 7A) de manière à définir la région du transistor; et

b. implantation d'ions possédant ledit second type de conductivité de manière à former ladite région d'émetteur (33B, figure 9A) et ladite région (44B, figure 9A) de traversée jusqu'au collecteur et élimination du masque de blocage;

c. réalisation de gorges (31) par corrosion sur les deux côtés de la région du transistor et s'étendant dans les régions isolantes d'oxyde en renforcement (21, 22).

6. Procédé pour fabriquer un circuit intégré selon la revendication 5, caractérisé par les phases opératoires suivantes de traitement:

a. au moyen d'une oxydation à basse température, formation d'une couche d'oxyde mince de 200 nm (49B, figure 9A) sur des parois latérales à nu desdites régions d'émetteur (43B, figure 9A), et d'une couche d'oxyde épais, d'une épaisseur de 50 nm (50B, figure 9A), sur la partie de ladite couche épitaxiale (12, figure 9A), située au-dessous;

b. moyennant l'utilisation d'une solution de corrosion de l'oxyde pendant un intervalle de temps suffisant, élimination de la couche d'oxyde mince (50B, figure 11A) déposée sur les parois latérales de la couche épitaxiale (12, figure 11A) moyennant le maintien d'une partie de ladite couche d'oxyde épaisse (49B) déposée autour de la paroi latérale de l'émetteur;

c. remplissage de la gorge (31) avec du poly-silicium (34) fortement dopé.

FIG. 1A

FIG. 1B

FIG. 1C

FIG. 2

FIG. 3

FIG. 4

FIG. 5

FIG. 6

FIG. 7

FIG. 7A

FIG. 9A

FIG. 11A

FIG. 8

FIG. 9

FIG. 10

FIG. 11

FIG. 12

FIG. 13

FIG. 14

FIG. 15

FIG. 16

FIG. 17

FIG. 18

FIG. 18B